## Europäisches Patentamt
## European Patent Office
## Office européen des brevets

(19)

(11) Numéro de publication: **0 137 553**
**B1**

(12) **FASCICULE DE BREVET EUROPEEN**

(45) Date de publication du fascicule du brevet:
**28.12.88**

(51) Int. Cl.⁴: **H 03 D 1/00, H 04 N 11/16**

(21) Numéro de dépôt: **84201333.6**

(22) Date de dépôt: **14.09.84**

(54) Procédé et circuit de démodulation numérique d'un signal modulé en amplitude et récepteur de télévision équipé d'un tel circuit.

(30) Priorité: **23.09.83 FR 8315135**

(43) Date de publication de la demande:
**17.04.85 Bulletin 85/16**

(45) Mention de la délivrance du brevet:
**28.12.88 Bulletin 88/52**

(84) Etats contractants désignés:
**DE FR GB**

(56) Documents cités:
**EP-A- 0 037 317**
**EP-A- 0 061 377**
**EP-A- 0 068 571**
**EP-A- 0 107 884**

(73) Titulaire: **Laboratoires d'Electronique et de Physique Appliquée L.E.P., 3, Avenue Descartes, F-94450 Limeil-Brévannes (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB**

(72) Inventeur: **Le Floch, Gérard, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

La présente invention concerne un procédé (revendication 1) et un circuit (revendication 2) de démodulation numérique d'un signal modulé en amplitude, résultant d'une modulation en amplitude, à porteuse supprimée, de deux porteuses de même fréquence en quadrature de phase, disposant d'une détermination du carré $a^2$ de l'amplitude crête $\underline{a}$ d'un signal de référence sinusoïdal synchrone dudit signal modulé et de possibilités d'échantillonnage; elle concerne également l'application d'un tel procédé par exemple à la réalisation d'un étage de démodulation du signal de chrominance d'un signal vidéofréquence d'un récepteur de télévision et, bien entendu, tout récepteur de télévision (revendication 9) équipé d'un tel étage de démodulation.

D'une part la demande de brevet français n° 8 218 254 du 29 octobre 1982 de la demanderesse (EP-A-0 107 884, publié le 9.5.84) décrit un circuit de démodulation dans lequel il est prévu de restituer, à partir du signal modulé, d'une part un premier signal numérique proportionnel à la fréquence du signal modulé, et d'autre part un second signal numérique proportionnel au carré de l'amplitude crête du signal modulé.

Il est nécessaire de décrire brièvement le procédé de démodulation mis en jeu pour la détermination de la fréquence et du carré de l'amplitude crête du signal modulé décrits dans ladite demande de brevet.

Si l'expression générale du signal analogique d'entrée est du type $x = a.\sin\omega t$, les signaux numériques en sortie des premier et second registres 20, 21 et du convertisseur analogique-numérique 10 ont respectivement pour expression, à fréquence d'échantillonnage constante ($Fe = 1/T$):

$$
\begin{aligned}
(1) \quad & x_n = a.\sin\omega t_n & \text{pour } t = t_n \\
(2) \quad & x_{n+1} = a.\sin(\omega t_n + \Phi) & \text{pour } t = t_n + T \\
(3) \quad & x_{n+2} = a.\sin(\omega t_n + 2\Phi) & \text{pour } t = t_n + 2T.
\end{aligned}
$$

A partir de ces trois mesures consécutives $x_n$, $x_{n+1}$, $x_{n+2}$, il est possible d'exprimer le cosinus du déphasage angulaire $\Phi$ par:

$$
(4) \quad \cos\Phi = \frac{x_n + x_{n+2}}{2x_{+1}}
$$

Comme il est évident que le déphasage $\Phi$ est égal à $\Phi = 2\pi.\dfrac{Fs}{Fe}$

où Fe est la fréquence d'échantillonnage choisie constante,

Fs est la fréquence du signal modulé ($Fs = \dfrac{\omega}{2\pi}$)

on obtient:

$$
(5) \quad Fs = Fe . \frac{Arc \cos\Phi)}{2\pi}
$$

ce qui permet de déterminer la fréquence du signal d'entrée, et par exemple, de démoduler le signal de chrominance qui, dans le cas du procédé SECAM, est modulé en fréquence.

D'une façon analogue à partir des trois mêmes mesures consécutives il est possible d'exprimer le carré de l'amplitude $\underline{a}$ du signal par les relations suivantes qui se déduisent aisément des relations (1) à (3) par de simples manipulations trigonométriques:

$$
(6) \quad a^2 = \frac{x_{n+1}^2 - x_n . x_n.x_{n+2}}{\sin^2\Phi}
$$

$$
(7) \quad a^2 = \frac{x_n^2 + x_{n+1}^2 - 2x_n . x_{n+1} . \cos\Phi}{\sin^2\Phi}
$$

En généralisant on peut écrire:

$$
(8) \quad a^2 = \frac{x_n^2 + x_p^2 - 2x_n . x_p . \cos[(p-n)\Phi]}{\sin^2[(p-n)\Phi]}
$$

D'autre part, le brevet français n° 2 502 423, correspondant au dépôt effectué le 17 mars 1981 (EP-A-0 061 377), décrit un démodulateur numérique de signaux de chrominance modulés en fréquence ou modulés en amplitude résultant d'une modulation en amplitude, à porteuse supprimée, de deux porteuses en quadrature de phase. Il y est décrit un procédé de démodulation basé sur une représentation du signal modulé en fréquence ou en amplitude par un vecteur tournant dans un repère OXY, ledit signal étant échantillonné par un signal ayant une fréquence 4F, c'est-à-dire 4 fois plus élevée que:

– soit la fréquence du milieu de la bande de fréquence pour le cas de la modulation de fréquence (SECAM);

– soit la fréquence de la porteuse dans le cas de la modulation d'amplitude (PAL).

Pour le cas de la modulation d'amplitude de type PAL qui présente un intérêt dans le cas présent, le procédé de démodulation est limité à l'échantillonnage du signal modulé par un signal à une fréquence 4F, le cas de la modulation d'amplitude étant ramené à celui de la modulation de fréquence où apparaissent des simplifications liées à des approximations concernant les écarts de fréquences.

Le document EP-A-0 037 317 concerne également un procédé et un démodulateur d'un signal modulé en amplitude. Ce document est cité et repris en partie dans le document EP-A-0 061 377 (brevet français n° 2 502 423) qui substitue le calcul d'un arc cosinus à celui d'un arc tangente du document EP-A-0 037 317. Dans les deux cas le but poursuivi est de déterminer la position d'un vecteur tournant (module et phase) en échantillonnant à la fréquence 4F. Ceci n'est pas effectué dans la demande.

Le but de l'invention est de proposer un procédé et un circuit de démodulation numérique tels que définis dans le préambule, remarquable en ce que

le cadencement d'une part et, d'autre art, les signaux de référence et modulé peuvent être synchrones ou asynchrones, ledit cadencement pouvant s'effectuer pour une large gamme de fréquence, la mise en œuvre du procédé faisant intervenir des relations algébriques simples.

L'invention concerne à cet effet un procédé de démodulation numérique d'un signal de type:

$$m_{p+1} = u.\cos(\alpha + k\Phi) + v.\sin(\alpha + k\Phi)$$
$$p \text{ et } k \text{ entiers}$$

caractérisé en ce qu'il comprend les étapes suivantes:

– à un instant choisi $t_{n+m}$, pour lequel on donne à k la valeur zéro, détermination puis stockage du signal du signal de référence $x_{n+m}$ et du signe de la dérivée dudit signal de référence;

– détermination pour l'instant $t_{n+m}$ du carré du sinus du déphasage angulaire initial appelé déphasage angulaire réel $\alpha_r$, ou l'inverse de ce carré selon la relation $1/\sin^2\alpha_r = a^2/x^2_{n+m}$;

– détermination des valeurs de $\sin \alpha_r$, puis d'une valeur $\alpha_T$ correspondant à une des valeurs de arc sin $\alpha_r$ choisie dans un des quatre quadrants d'une représentation trigonométrique usuelle;

– détermination de la valeur du déphasage angulaire réel $\alpha_r$ à partir de la valeur de $\alpha_T$, de la connaissance du quadrant choisi, et des signes du signal de référence et de la dérivée dudit signal de référence pour le même instant $t_{n+m}$;

– détermination puis stockage successifs à chaque instant de la cadence de valeurs $\alpha_r + k\Phi$ modulo $2\pi$;

– détermination et stockage successifs des couples de valeurs de $\sin(\alpha_r + k\Phi)$ et $\cos(\alpha_r + K\Phi)$, $\sin(\alpha_r + (k-1)\Phi)$ et $\cos(\alpha_r + (k-1)\Phi)$ pour deux instants consécutifs de la cadence;

– détermination des valeurs proportionnelles aux signaux modulants u et v, à partir de deux échantillons $m_p$ et $m_{p+1}$ du signal modulé, par:

$m_p.\sin(\alpha_r + k\Phi) - m_{p+1}.\sin(\alpha_r + (k-1)\Phi)$ proportionnel à u et: $m_{p+1}.\cos(\alpha_r + (k-1)\Phi) - m_p.\cos(\alpha_r + k\Phi)$ proportionnel à v.

Les particularités et avantages de l'invention apparaîtront dans la description ci-après ainsi que dans les dessins non limitatifs donnés à titre d'exemple:

– la figure 1a montre le premier circuit 11 de détermination du carré $a^2$ de l'amplitude crête selon le procédé connu et le troisième circuit 13 de détermination de la valeur du déphasage angulaire réel, conforme à l'invention;

– la figure 1b montre le second circuit 12 calculant la dérivée du signal de référence, les valeurs de $1/x^2_{n+m}$, le signe du signal de référence et celui de sa dérivée;

– la figure 1c montre le quatrième circuit 14 calculant les valeurs $\alpha_r + k\Phi$ à l'issue de chaque période de cadencement, et les valeurs $\sin(\alpha_r + k\Phi)$ et $\cos(\alpha_r + k\Phi)$ pour deux instants consécutifs de la cadence;

– la figure 1d montre le cinquième circuit 15 calculant les composantes en phase et en quadrature dudit signal de modulation;

– la figure 2 montre le circuit de multiplexage d'entrée du dispositif de calcul 62 selon un autre mode de réalisation.

Le procédé et le circuit de démodulation numérique d'amplitude selon l'invention peuvent traiter, dans un exemple préférentiel, les informations de chrominance selon le procédé PAL. Pour cela, la ligne de télévision et le traitement temporel qui en découle sont successivement séparés en un traitement sur la salve, prise dans ce cas comme référence, puis en un traitement de la partie de ladite ligne qui contient les informations de chrominance, prise comme signal modulé à analyser.

Le traitement sur la salve est destiné à déterminer à chaque ligne les informations d'amplitude et de phase qui sont exploitées pendant le traitement ultérieur des informations de chrominance.

La salve est une onde sinusoïdale pure de fréquence parfaitement stabilisée qui peut être représentée par $x = a.\sin\omega t$ où $\omega = 2\pi Fs$ avec $Fs$ fréquence de la salve. Ce signal est échantillonné par un signal à la fréquence de cadencement $Fe$.

A la sortie du convertisseur analogique-numérique 10, du premier registre 20 et du second registre 21 on dispose respectivement des échantillons $x_{n+2}$, $x_{n+1}$, $x_n$ tels que: $x_n = a \sin(\omega t_n)$, $x_{n+1} = a \sin(\omega t_n + \Phi)$, $x_{n+2} = a \sin(\omega t_n + 2\Phi)$. Il est évident que le déphasage angulaire entre la salve et le signal de cadencement est égal à $\Phi = 2\pi\dfrac{Fs}{Fe}$.

Selon le procédé connu, en opérant le calcul de l'expression (6), on peut déterminer le carré de l'amplitude crête du signal de salve.

Dans le procédé de télévision connu PAL, la fréquence de la salve est parfaitement constante. En opérant avec une fréquence de cadencement constante le déphasage angulaire $\Phi$ est constant et parfaitement déterminé. Il en est de même pour $\sin^2\Phi$ qui se trouve être une constante dans le calcul de $a^2$. Ce calcul est effectué selon le procédé connu de ladite demande de brevet de la demanderesse où le second dispositif de calcul 23 est, par exemple, un multiplieur numérique et le premier dispositif de calcul 22 une mémoire stockant tous les résultats de $x^2_{n+1}$ déjà précalculés. Le troisième dispositif de calcul 24 est, par exemple un soustracteur, ou un additionneur dans le cas d'une représentation en complément à 2 des données numériques. Le cinquième dispositif de calcul 32 reçoit sur une entrée le résultat de l'opération $x^2_{n+1} - x_n.x_{n+2}$ et sur l'autre entrée une valeur numérique définie représentant $1/\sin^2\Phi$ si le cinquième dispositif de calcul 32 est un multiplieur. Cette valeur numérique représenterait $\sin^2\Phi$ si ce cinquième dispositif de calcul 32 était un diviseur. Dans les deux cas on obtient la valeur de $a^2$ tel que défini par l'équation (6). Ceci est déjà décrit dans ladite demande de brevet déposée par la demanderesse.

Le quatrième dispositif de calcul 31 permet, dans le cas où la fréquence du signal modulé ou celle du cadencement ne sont pas réellement constantes, d'opérer le calcul de $1/\sin^2\Phi$ ou $\sin^2\Phi$

à partir de mesures préalables d'un paramètre lié au déphasage angulaire, par exemple cos$\Phi$. Ce dispositif de calcul peut être omis si ces deux fréquences sont parfaitement constantes, auquel cas la valeur de $1/\sin_2\Phi$ ou $\sin^2\Phi$ est entrée directement dans le cinquième dispositif de calcul 32.

Les particularités et avantages de l'invention apparaîtront maintenant dans la description suivante.

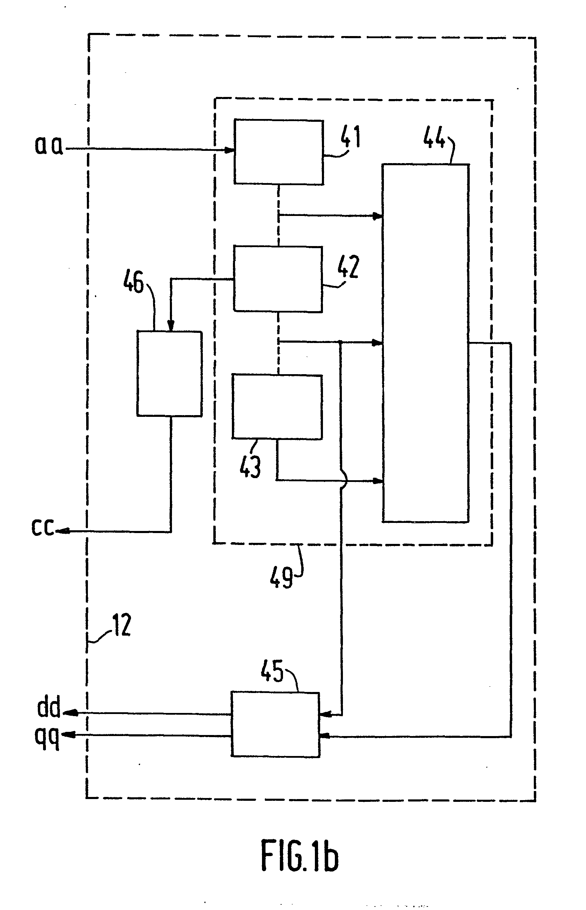

Les données numériques par exemple celles de la sortie du second registre 21, entrent dans le sous-circuit 49 (figure 1b) déterminant la dérivée du signal d'entrée, par exemple par le procédé connu de filtrage numérique par exemple décrit dans la demande de brevet n° 8 112 412 du 24 juin 1981 de la demanderesse. Le sixième dispositif de calcul 44 utilise les informations $x_{n+m+i}$ à $x_{n+m-j}$ d'une série de $i+j+1$ registres, par exemple celles d'un troisième registre 41 à celle d'un cinquième registre 43. Autour d'un instant $t_{n+m}$ on a donc stocké l'information $x_{n+m}$, les j informations précédentes et les i informations suivantes. En pondérant chaque information par un coefficient on calcule la dérivée selon une expression générale du genre:

$$(9) \quad Y(p) = \sum_{p = n + m - j}^{p = n + m + i} a_p \cdot X_p.$$

Avantageusement ce filtre numérique aura un nombre impair ($i = j$) de registres afin que le calcul de la dérivée soit déterminé pour un instant de cadencement durant lequel la donnée $x_{n+m}$ est stockée dans le quatrième registre 42. Un filtre numérique pair ($i = j$) peut aussi être utilisé mais avec des aménagements sur le cadencement. De même avantageusement le filtre numérique utilisera des coefficients $a_p$ égaux à des puissances entières de 2 afin d'effecteur le calcul selon l'équation (9) par de simples décalages de données numériques. Le but étant de ne conserver que le signe de cette dérivée, la complexité du filtre n'est limitée que par l'obtention du signe correct sans que la valeur numérique elle-même ait une importance. Ainsi un filtre à 3 registres, par exemple, a donné satisfaction avec des décalages de données pour le calcul. Le signe de cette dérivée et celui de l'échantillon $x_{n+m}$ qui lui correspond sont conservés dans un dispositif à mémoire 45 pour l'exploitation ultérieure.

Les valeurs numériques de $x_{n+m}$ entrent dans un septième dispositif de calcul 46 donnant en sortie les valeurs $1/x^2_{n+m}$ correspondantes. Avantageusement ledit septième dispositif de calcul 46 est constitué d'un dispositif à mémoire stockant les valeurs déjà précalculées.

On dispose ainsi en sortie du second circuit 12, du signal cc pour les valeurs de $1/x^2_{n+m}$ et des signaux dd et qq pour les deux dits signes. Ce second circuit 12 opère, après que la détermination de $a^2$ ait été faite, pour un instant voisin de la fin de la salve mais préalable au début de l'apparition des informations de chrominance de la ligne. Cet instant est défini par la rapidité de fonctionnement des dispositifs utilisés.

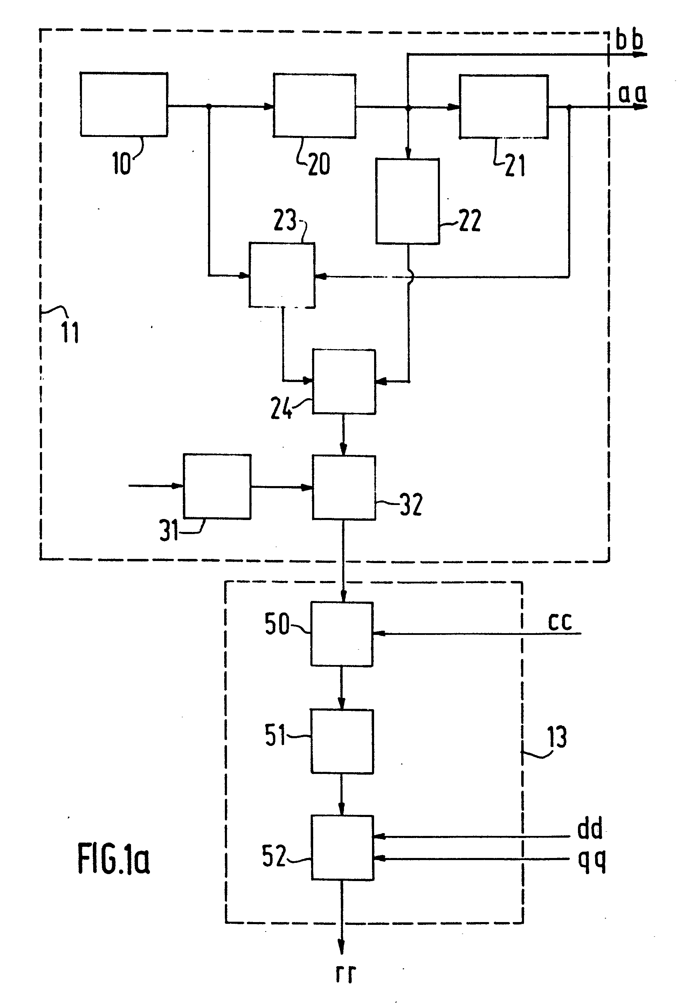

Le signal cc entre dans le huitième dispositif de calcul 50 (figure 1a) constitué par exemple par un multiplieur qui effectue le calcul de $1/\sin^2\alpha_r$ selon:

$$(10) \quad 1/\sin^2\alpha_r = a^2/x^2_{n+m}.$$

Le neuvième dispositif de calcul 51 permet à partir des valeurs de $1/\sin^2\alpha_r$ de déterminer des valeurs appelées $\alpha_T$ définies par $\alpha_T = $ arc $\sin\alpha_r$ calculées par exemple, dans le premier quadrant $(0,\pi/2)$ d'une représentation trigonométrique usuelle. La détermination des valeurs de $\alpha_r$ se fait dans le dixième dispositif de calcul 52 en considérant les signes de la dérivée et du signal pour le même échantillon que celui traité dans la relation (10) selon le tableau:

|  | Signe du signal | signe de la dérivée | Calcul à effectuer |
|---|---|---|---|
| 1er quadrant | $+$ | $+$ | $\alpha_r = \alpha_T$ |
| 2ème quadrant | $+$ | $-$ | $\alpha_r = \pi - \alpha_T$ |
| 3ème quadrant | $-$ | $-$ | $\alpha_r = \pi + \alpha_T$ |
| 4ème quadrant | $-$ | $+$ | $\alpha_r = 2\pi - \alpha_T$ |

Si $\alpha_T$ est calculé dans un autre quadrant, donc décalé de $\pi/2$, $\pi$ ou $\dfrac{3\pi}{2}$, il est nécessaire d'en tenir compte pour effectuer les calculs du tableau d'une manière qui est évidente pour l'homme de l'art.

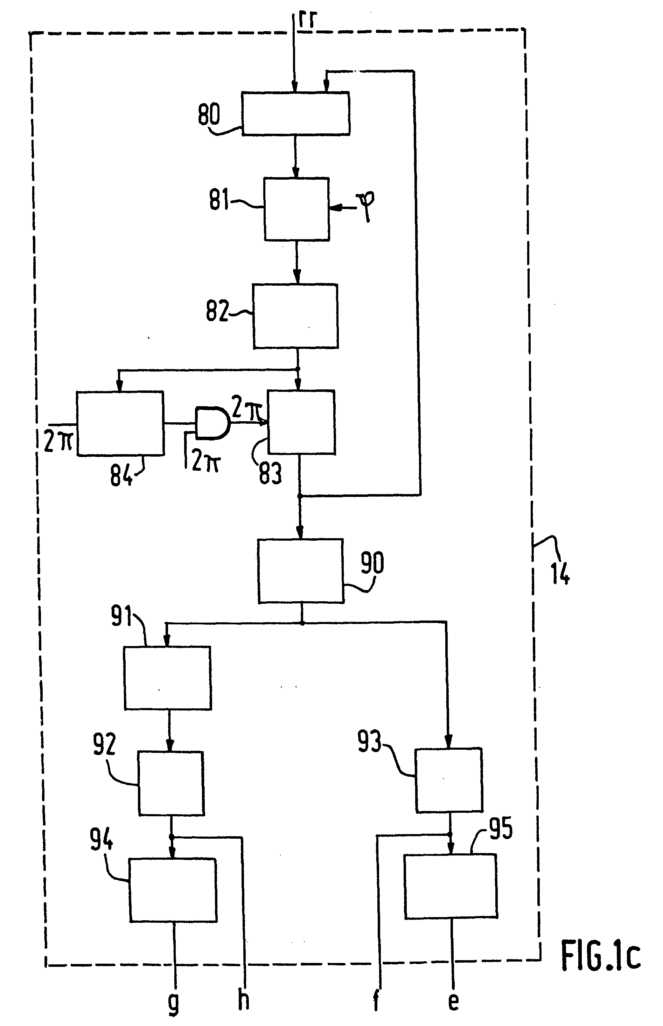

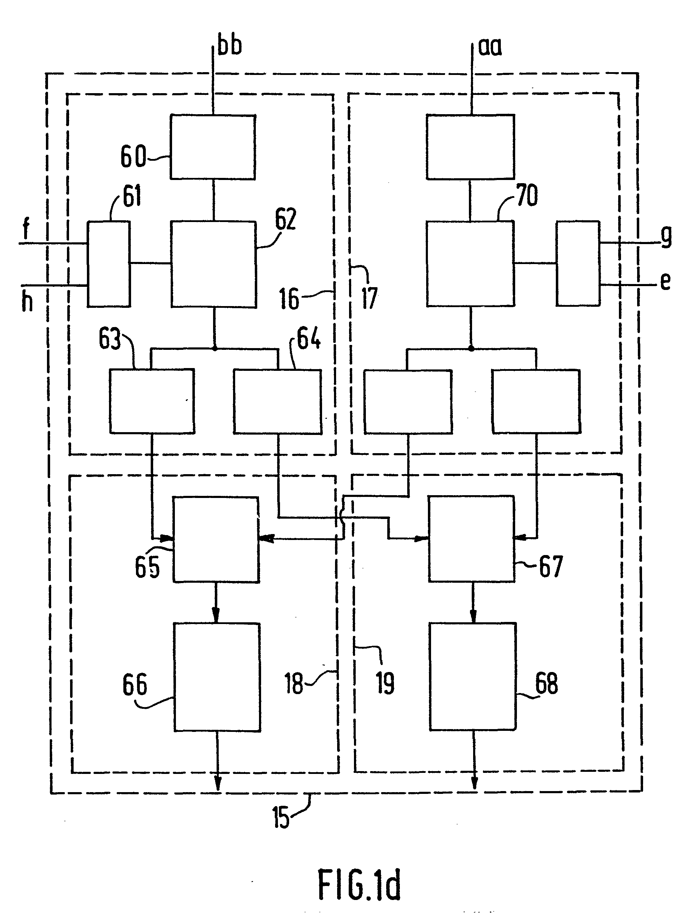

La valeur de $\alpha_r$ est obtenue à la sortie du dixième dispositif de calcul 52 (signal rr). Cette valeur $\alpha_r$ est introduite dans le quatrième circuit 14 (figure 1c) qui va, pour chaque période de cadencement choisi, incrémenter la valeur $\alpha_r$ de la valeur de $\Phi = 2\pi.\dfrac{Fs}{Fe}$ puis les valeurs ainsi obtenues

selon l'équation:

$$\alpha_r \text{ (nouvelle)} = \alpha_r \text{ (ancienne)} + \Phi$$

la comparer chaque fois à la valeur $2\pi$, et effectuer si nécessaire la soustraction de la valeur $2\pi$ afin de conserver la valeur de $\alpha_r$ dans l'intervalle $(0,2\pi)$.

Pour cela le quatrième circuit 14 est constitué de:

a) un premier multiplexeur d'entrée 80 sélectionnant la valeur de $\alpha_r$ issue du dixième dispositif de calcul 52 puis les valeurs successives $\alpha_r + k\Phi$ issues du douzième dispositif de calcul 83;

b) un onzième dispositif de calcul 81 recevant sur sa première entrée la sortie du premier multiplexeur 80 et sur sa seconde entrée une représentation numérique du déphasage angulaire $\Phi =$

$$2\pi.\frac{Fs}{Fe};$$

c) un sixième registre 82 destiné à répartir sur deux temps successifs dudit cadencement choisi, le fonctionnement du circuit en boucle fermée formé du premier multiplexeur 80, du onzième dispositif de calcul 81, du douzième dispositif de calcul 83 et dudit sixième registre 82;

d) un comparateur numérique 84 opérant la comparaison de la sortie du sixième registre 82 avec une représentation numérique de la constante $2\pi$;

e) un douzième dispositif de calcul 83 opérant la soustraction d'une représentation numérique de la constante $2\pi$, lorsque le comparateur 84 détecte que le résultat présent à la sortie du sixième registre 82 est supérieur à la constante $2\pi$.

Les septième 90 et huitième 91 registres conservent les valeurs calculées pendant une période de cadencement, ceci étant nécessité par le fonctionnement alterné des dispositifs de calcul suivants décrits ci-après. Le quatorzième dispositif de calcul 93, par exemple une mémoire stockant une table précalculée, fournit pour chaque période de cadencement la valeur $\sin(\alpha_r + k\Phi)$ {signal f} dont la valeur précédente $\sin(\alpha_r + (k-1)\Phi)$ {signal e} apparaît à la sortie du dixième registre 95. D'une façon similaire, le signal h correspond à la valeur $\cos(\alpha_r + k\Phi)$ et le signal g correspond à la valeur $\cos(\alpha_r + (k-1)\Phi)$ issus respectivement du treizième dispositif de calcul 92 et du neuvième registre 94.

En considérant maintenant que la représentation des deux signaux modulant deux porteuses de même fréquence mais en quadrature de phase est:

(11)   $m_p = u.\cos(\alpha_r + (k-1)\Phi) + v \sin(\alpha_r + (k-1)\Phi)$

l'échantillon suivant sera représenté par:

(12)   $m_{p+1} = u.\cos(\alpha_r + k\Phi) + v \sin(\alpha_r + k\Phi)$.

En appelant:

$e = \sin(\alpha_r + (k-1)\Phi)$    $f = \sin(\alpha_r + k\Phi)$
$g = \cos(\alpha_r + (k-1)\Phi)$    $h = \cos(\alpha_r + k\Phi)$

il est aisé d'arriver à:

$$u = \frac{m_p . f - m_{p+1} . e}{g . f - h . e} \quad \text{et}$$

$$v = \frac{m_{p+1} . g - m_p . h}{g . f - h . e}$$

Or on montre que $g.f - h.e = \sin\Phi$. Cette valeur est une constante dans le cas de la modulation d'amplitude d'une ou plusieurs porteuses ayant une fréquence constante. On en déduit que les composantes u et v sont respectivement proportionnelles à $m_p.f - m_{p+1}.e$ et $m_{p+1}.g - m_p.h$. Dans une réalisation expérimentale la précision du calcul, donc le nombre d'éléments binaires constituant les données, est à adapter à la valeur de $\sin\Phi$.

Les échantillons $m_p$ (équation 11) issus du premier circuit 11, par exemple à la sortie du premier registre 20 (signal bb), entrent dans le dispositif à retard 60 du cinquième circuit 15 (figure 1d) tandis que les échantillons $m_{p+1}$ (équation 12) issus dudit premier circuit 11 décalés d'un temps de cadencement par rapport à l'échantillon $m_p$, par exemple pris à la sortie du second registre 21 (signal aa), entrent dans le cinquième circuit 15 dans un autre dispositif à retard identique au dispositif à retard 60. Ces dispositifs assurent la concordance de phase des informations arrivant sur les quinzième 62 et dix-huitième 70 dispositifs de calcul. Le deuxième multiplexeur 61 reçoit les deux résultats f et h et le quinzième dispositif de calcul 62 détermine, en alternance tous les deux temps de cadencement, les valeurs des produits $m_p.h$ et $m_p.f$ stockés chacun pour chacun desdits deux temps dans les onzième 63 et douzième 64 registres. D'une façon identique le septième circuit 17 fournit les résultats des calculs des produits $m_{p+1}.g$ et $m_{p+1}.e$. La phase et le cadencement sont définis de façon à ce que le seizième dispositif de calcul 65, par exemple un soustracteur, effectue l'opération $m_{p+1}.g - m_p.h$. Les résultats obtenus après chaque instant de cadencement sont stockés pour toute la durée d'une ligne d'information chrominance et conservés pendant la ligne suivante dans le premier circuit de mémorisation et de calcul 66 qui opère également le traitement desdites deux lignes consécutives selon les principes habituels de traitement d'un signal selon le procédé PAL.

Le dix-septième dispositif de calcul 67 effectue un traitement similaire au seizième dispositif de calcul 65 mais sur les échantillons $m_p.f$ et $m_{p+1}.e$ pour l'autre phase de cadencement. Les résultats obtenus à l'issue de l'opération $m_p.f - m_{p+1}.e$ sont stockés dans le second circuit de mémorisation et de calcul 68.

On obtient en sortie du cinquième circuit 15 les deux composantes u et v en phase entre elles, avec une fréquence de cadencement moitié de celle, par exemple, du quinzième dispositif de calcul 62.

L'invention concerne ainsi un circuit numérique pour la mise en œuvre d'un procédé de démodulation numérique d'un signal, modulé en amplitude, résultant d'une modulation en amplitude, à porteuse supprimée, de deux porteuses de même fréquence Fs en quadrature de phase, disposant d'une détermination du carré $a^2$ de l'amplitude crête $\underline{a}$ d'un signal de référence sinusoïdal synchrone $\overline{du}$ signal modulé, et de possibilités d'échantillonnage à une cadence définie par une fréquence Fe, ledit signal modulé s'écrivant:

$$m_{p+1} = u.\cos(\alpha + k\Phi) + v.\sin(\alpha + k\Phi)$$

où $\Phi = \dfrac{\omega}{Fe} = 2\pi\dfrac{Fs}{Fe}$, $\alpha$ étant un déphasage angulaire initial et $k$ le nombre de périodes $T = 1/Fe$, le circuit numérique comprenant un premier circuit 11 permettant de déterminer le carré $a^2$ de l'amplitude crête $\underline{a}$ d'un signal de référence synchrone dudit signal modulé, ledit premier circuit 11 comprenant un convertisseur analogique-numérique 10, un premier 20 et un second registre 21, un premier 22, un second 23, un troisième 24, un quatrième 31 et un cinquième 32 dispositif de calcul, ce dernier délivrant en sortie des échantillons représentatifs du carré $a^2$ de l'amplitude crête dudit signal de référence, caractérisé en ce qu'il comprend:

A. un second circuit 12 permettant de déterminer pour un instant choisi $t_{n+m}$ où apparaît un échantillon $x_{n+m}$ le signe du signal de référence et le signe de la dérivée dudit signal de référence pour ce même dit instant, constitué de:

  a. un sous-circuit 49 de détermination de la dérivée d'un signal, par exemple de type filtre numérique, lui-même constitué de:

    a1) en série, un certain nombre de registres, par exemple un troisième 41, un quatrième 42 et un cinquième 43 registre, destinés à stocker des échantillons successifs $x_{n+m+i}$ à $x_{n+m-j}$, issus par exemple du second registre 21;

    a2) un sixième dispositif de calcul 44 recevant les échantillons $x_{n+m+i}$ à $x_{n+m-j}$, calculant par la méthode connue de filtrage numérique, et pour l'instant $t_{n+m}$, la dérivée du signal représenté par lesdits échantillons;

  b. un dispositif à mémoire 45 destiné à conserver lesdites informations de signe du signal de référence et de signe de la dérivée du même signal de référence;

  c. un septième dispositif de calcul 46 réuni en entrée à la sortie du quatrième registre 42 stockant $x_{n+m}$, délivrant des échantillons représentatifs de la fonction $1/x^2_{n+m}$;

B. un troisième circuit 13 permettant de calculer le déphasage angulaire $\alpha_r$ modulo $2\pi$, pour ledit échantillon $x_{n+m}$, constitué de:

  a. un huitième dispositif de calcul 50 recevant les informations issues des cinquième 32 et septième 46 dispositifs de calcul, délivrant en sortie des échantillons représentatifs de la fonction $1/\sin^2 a_r = a^2/x^2_{n+m}$;

  b. un neuvième dispositif de calcul 51 réuni en entrée à la sortie du huitième dispositif de calcul 50, délivrant en sortie des échantillons, ci-après nommés $\alpha_T$, représentant la fonction arc sin $\alpha_r$, déterminés pour un des quatre quadrants, choisi au départ, d'une représentation trigonométrique usuelle;

  c. un dixième dispositif de calcul 50 réuni en entrée à la sortie du neuvième dispositif de calcul 51 et aux deux sorties du dispositif à mémoire 45, opérant, à partir de la valeur de $\alpha_T$, le calcul du déphasage angulaire réel $\alpha_r$ dans l'intervalle 0 à $2\pi$;

C. un quatrième circuit 14, traitant le signal modulé à l'issue du calcul de $\alpha_r$, délivrant, avec le cadencement régulier choisi, les valeurs représentatives des fonctions $\sin(\alpha_r + k\Phi)$, $\sin(\alpha_r + (k-1)\Phi)$, $\cos(\alpha_r + k\Phi)$, $\cos(\alpha_r + (k-1)\Phi)$, relatives au signal modulé constitué de:

  a. un premier multiplexeur d'entrée 80 sélectionnant la valeur de $\alpha_r$ issue du dixième dispositif de calcul 52 puis les valeurs successives $\alpha_r + k\Phi$ issues d'un douzième dispositif de calcul 83;

  b. un onzième dispositif de calcul 81 recevant sur sa première entrée la sortie du premier multiplexeur 80 et sur sa seconde entrée une représentation numérique du déphasage angulaire $\Phi$;

  c. un sixième registre 82 destiné à répartir sur deux temps successifs dudit cadencement choisi, le fonctionnement du circuit en boucle fermée formé du premier multiplexeur 80, du onzième dispositif de calcul 81, du douzième dispositif de calcul 83 et dudit sixième registre 82;

  d. comparateur numérique 84 opérant la comparaison de la sortie du sixième registre 82 avec une représentation numérique de la constante $2\pi$;

  e. un douzième dispositif de calcul 83 délivrant $\alpha_r$ modulo $2\pi$;

  f. un septième registre 90 destiné à conserver à la cadence choisie, le résultat du calcul issu du douzième dispositif de calcul 83;

  g. un huitième registre 91 destiné à retarder d'un cycle de ladite cadence le signal de sortie du septième registre 90;

  h. un treizième 92 et quatorzième 93 dispositif de calcul donnant respectivement les valeurs des fonctions $\sin(\alpha_r + k\Phi)$ et $\cos(\alpha_r + k\Phi)$;

  i. un neuvième 94 et un dixième 95 registre conservant, au rythme du cadencement, les valeurs antérieures des résultats précédents $\sin(\alpha_r + (k-1)\Phi)$ et $\cos(\alpha_r + (k-1)\Phi)$;

D. un cinquième circuit 15 constitué de:

  a. un sixième circuit 16 destiné à calculer les éléments permettant eux-mêmes de calculer l'amplitude d'un des signaux modulants constitué de:

    a1) un dispositif à retard 60 retardant les échantillons $m_p$ prélevés par exemple en sortie du premier registre 20, afin que les échantillons arrivant sur les deux entrées d'un quinzième dispositif de calcul 62 soient en phase;

a2) un deuxième multiplexeur 61 relié en entrée aux sorties du treizième 92 et quatorzième 93 dispositif de calcul;

a3) un quinzième dispositif de calcul 62 relié en entrée à la sortie du deuxième multiplexeur 61 et à celle du dispositif à retard 60, délivrant successivement à la cadence choisie, des échantillons représentatifs des produits $m_p.cos(\alpha_r+k\Phi)$ et $m_p.sin(\alpha_r+k\Phi)$;

a4) un onzième registre 63 recevant les résultats $m_p.cos(\alpha_r+k\Phi)$ et un douzième registre 64 recevant les résultats $m_p.sin(\alpha_r+k\Phi)$, les deux dits registres fonctionnant en alternance à une cadence deux fois moins rapide que celle des circuits précédents;

b. un septième circuit 17 de conception identique au sixième circuit 16, recevant en entrée les échantillons $m_{p+1}$ décalés d'un temps de cadencement par rapport aux échantillons $m_p$, prélevés par exemple en sortie du deuxième registre 21, ledit septième circuit 17 ayant un dix-huitième dispositif de calcul 70 délivrant en alternance sur ses sorties des échantillons représentatifs des produits $m_{p+1}.cos(\alpha_r+(k-1)\Phi)$ et $m_{p+1}.sin(\alpha_r+(k-1)\Phi)$;

c. un seizième dispositif de calcul 65 réuni en entrée à celles des sorties, respectivement des sixième 16 et septième 17 circuits, qui ont la même alternance de la cadence deux fois moins rapide, délivrant des échantillons représentatifs de l'opération $m_{p+1}.cos(\alpha_r+(k-1)\Phi)-m_p.cos(\alpha_r+k\Phi)$ représentant le signal modulant v;

d. un dix-septième dispositif de calcul 67 de conception identique au seizième dispositif de calcul 65 mais opérant sur les échantillons issus, respectivement, des sixième 16 et septième 17 circuits, avec l'autre alternance de la cadence deux fois moins rapide, délivrant des échantillons proportionnels à $m_p.sin(\alpha_r+k\Phi) - m_{p+1}.sin(\alpha_r+(k-1)\Phi)$ représentant le signal modulant u, le cadencement d'une part et, d'autre part, les signaux de référence et modulé pouvant être synchrones ou asynchrones, ledit cadencement pouvant s'effectuer pour une large gamme de fréquences.

Le cadencement peut s'effectuer dans une très large gamme de fréquences. Il est connu que la limite inférieure de la fréquence de cadencement est définie de telle sorte que l'on dispose au minimum de 2 échantillons par période du signal à analyser pour la fréquence la plus élevée dudit signal à analyser. Pour un échantillonnage correct de la porteuse elle-même, la limite inférieure sera donc $Fe \geqslant 2.(F_{Port})_{max}$. Dans le cas où seul ledit signal modulant est recherché, la limite inférieure sera $Fe \geqslant 2.(F_{Mod})_{max}$ le fonctionnement s'opérant, par exemple, selon l'équation (8). Cette seconde limitation moins restrictive doit néanmoins être relevée en tenant compte de la définition recherchée, donc du nombre d'échantillons, pour la restitution correcte dudit signal modulant.

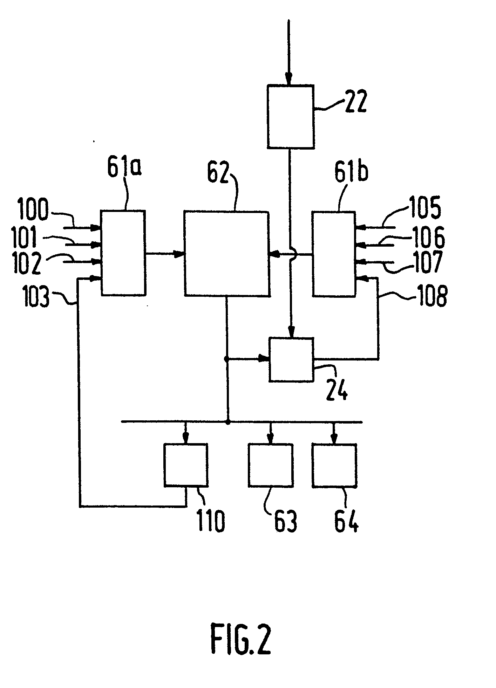

Sans s'écarter du but de l'invention on peut envisager différentes variantes à la description qui vient d'être faite. En particulier, il est avantageux de faire que le quinzième dispositif de calcul 62 par exemple (figure 2), effectue les calculs des second 23, cinquième 32 et huitième 50 dispositifs de calcul, en opérant un multiplexage plus étendu dudit quinzième dispositif de calcul 62. Ainsi, le troisième multiplexeur 61a reçoit:
- le signal 100 représentant $x_{n+2}$
- le signal 101 représentant $m_p$
- le signal 102 représentant $1/sin^2\Phi$
- le signal 103 issu de la sortie du registre 110.

De même, le quatrième multiplexeur 61b reçoit:
- le signal 105 représentant $x_n$
- le signal 106 représentant f
- le signal 107 représentant h
- le signal 108 issu du troisième dispositif de calcul 24.

Le registre 110 conserve les résultats du calcul de $a^2$ pour son utilisation ultérieure.

Il est de même possible de multiplexer différemment les quinzième 62 et dix-huitième 70 dispositifs de calcul pour les différentes opérations à effectuer sans sortir du but de l'invention.

Il faut noter que l'invention ne s'applique pas seulement à la démodulation d'un signal de chrominance PAL, mais peut aussi être utilisée pour démoduler tout signal résultant d'une modulation d'amplitude à porteuse supprimée, de deux porteuses de même fréquence et en quadrature de phase et possédant un signal de référence sinusoïdal synchrone.

De même, par un multiplexage plus étendu du quinzième 62 et/ou du dix-huitième 70 dispositif de calcul on effectue la démodulation de la fréquence et de l'amplitude d'un signal modulé en fréquence, par exemple le signal de chrominance de type SECAM, selon le procédé connu représenté par les équations (4) et (6). On dispose ainsi d'un récepteur de télévision permettant de démoduler les informations de chrominance selon, au choix, les procédés PAL et/ou SECAM.

**Revendications**

1. Procédé de démodulation numérique d'un signal modulé en amplitude, résultant d'une modulation en amplitude, à porteuse supprimée, de deux porteuses de même fréquence Fs en quadrature de phase, disposant d'une détermination du carré $a^2$ de l'amplitude crête $\overline{a}$ d'un signal de référence sinusoïdal synchrone du signal modulé, et de possibilités d'échantillonnage à une cadence définie par une fréquence Fe, ledit signal modulé s'écrivant:

$$m_{p+1} = u.cos(\alpha+k\Phi) + v.sin(\alpha+k\Phi)$$

où $\Phi = \dfrac{\omega}{Fe} = 2\pi\dfrac{Fs}{Fe}$, $\alpha$ est un déphasage angulaire initial et k le nombre de périodes T = 1/Fe, caractérisé en ce qu'il comprend les étapes suivantes:

   — à un instant choisi $t_{n+m}$, pour lequel on donne à k la valeur zéro, détermination puis stockage du signe du signal de référence $x_{n+m}$ et du signe de la dérivée dudit signal de référence;

   — détermination pour l'instant $t_{n+m}$ du carré du sinus du déphasage angulaire initial appelé déphasage angulaire réel $\alpha_r$, ou l'inverse de ce carré selon la relation $1/\sin^2\alpha_r = a^2/x^2_{n+m}$;

   — détermination des valeurs de $\sin \alpha_r$, puis d'une valeur $\alpha_T$ correspondant à une des valeurs de arc $\sin \alpha_r$ choisie dans un des quatre quadrants d'une représentation trigonométrique usuelle;

   — détermination de la valeur du déphasage angulaire réel $\alpha_r$ à partir de la valeur de $\alpha_T$, de la connaissance du quadrant choisi, et des signes du signal de référence et de la dérivée dudit signal de référence pour le même instant $t_{n+m}$;

   — détermination puis stockage successifs à chaque instant de la cadence des valeurs $\alpha_r + k\Phi$ modulo $2\pi$;

   — détermination et stockage successifs des couples de valeurs de $\sin(\alpha_r + k\Phi)$ et $\cos(\alpha_r + k\Phi)$, $\sin(\alpha_r + (k-1)\Phi)$ et $\cos(\alpha_r + (k-1)\Phi)$ pour deux instants consécutifs de la cadence;

   — détermination des valeurs proportionnelles aux signaux modulants u et v, à partir de deux échantillons $m_p$ et $m_{p+1}$ du signal modulé, par:

   $m_p.\sin(\alpha_r + k\Phi) - m_{p+1}.\sin(\alpha_r + (k-1)\Phi)$ proportionnel à u et, $m_{p+1}.\cos(\alpha_r + (k-1)\Phi) - m_p.\cos(\alpha_r + k\Phi)$ proportionnel à v.

   2. Circuit numérique pour la mise en œuvre d'un procédé de démodulation numérique d'un signal, modulé en amplitude, résultant d'une modulation en amplitude, à porteuse supprimée, de deux porteuses de même fréquence Fs en quadrature de phase, disposant d'une détermination du carré $a^2$ de l'amplitude crête $\underline{a}$ d'un signal de référence sinusoïdal synchrone $\overline{d}u$ signal modulé, et de possibilités d'échantillonnage à une cadence définie par une fréquence Fe, ledit signal modulé s'écrivant:

$$m_{p+1} = u.\cos(\alpha + k\Phi) + v.\sin(\alpha + k\Phi)$$

où $\Phi = \dfrac{\omega}{Fe} = 2\pi\dfrac{Fs}{Fe}$, $\alpha$ étant un déphasage angulaire initial et k le nombre de périodes T = 1/Fe, le circuit numérique comprenant un premier circuit (11) permettant de déterminer le carré $a^2$ de l'amplitude crête $\underline{a}$ d'un signal de référence synchrone dudit signal modulé, ledit premier circuit (11) comprenant un convertisseur analogique-numérique (10), un premier (20) et un second registre (21), un premier (22), un second (23), un troisième (24), un quatrième (31) et un cinquième (32) dispositif de calcul, ce dernier délivrant en sortie des échantillons représentatifs du carré $a^2$ de l'amplitude crête dudit signal de référence, caractérisé en ce qu'il comprend:

A. un second circuit (12) permettant de déterminer pour un instant choisi $t_{n+m}$ où apparaît un

échantillon $x_{n+m}$ le signe du signal de référence et le signe de la dérivée dudit signal de référence pour ce même dit instant, constitué de:

a. un sous-circuit (49) de détermination de la dérivée d'un signal, par exemple de type filtre numérique, lui-même constitué de:

   a1) en série, un certain nombre de registres, par exemple un troisième (41), un quatrième (42) et un cinquième (43) registre, destinés à stocker des échantillons successifs $x_{n+m+i}$ à $x_{n+m-j}$, issus par exemple du second registre (21);

   a2) un sixième dispositif de calcul (44) recevant les échantillons $x_{n+m+i}$ à $x_{n+m-j}$, calculant par la méthode connue de filtrage numérique, et pour l'instant $t_{n+m}$, la dérivée du signal représenté par lesdits échantillons;

b. un dispositif à mémoire (45) destiné à conserver lesdites informations de signe du signal de référence et de signe de la dérivée du même signal de référence;

c. un septième dispositif de calcul (46) réuni en entrée à la sortie du quatrième registre (42) stockant $x_{n+m}$, délivrant des échantillons représentatifs de la fonction $1/x^2_{n+m}$;

B. un troisième circuit (13) permettant de calculer le déphasage angulaire $\alpha_r$ modulo $2\pi$, pour ledit échantillon $x_{n+m}$, constitué de:

a. un huitième dispositif de calcul (50) recevant les informations issues des cinquième (32) et septième (46) dispositifs de calcul, délivrant en sortie des échantillons représentatifs de la fonction $1/\sin^2\alpha_r = a^2/x^2_{n+m}$;

b. un neuvième dispositif de calcul (51) réuni en entrée à la sortie du huitième dispositif de calcul (50), délivrant en sortie des échantillons, ci-après nommés $\alpha_T$, représentant la fonction arc $\sin \alpha_r$, déterminés pour un des quatre quadrants, choisi au départ, d'une représentation trigonométrique usuelle;

c. un dixième dispositif de calcul (52) réuni en entrée à la sortie du neuvième dispositif de calcul (51) et aux deux sorties du dispositif à mémoire (45), opérant, à partir de la valeur de $\alpha_T$, le calcul du déphasage angulaire réel $\alpha_r$ dans l'intervalle 0 à $2\pi$;

C. un quatrième circuit (14), traitant le signal modulé à l'issue du calcul de $\alpha_r$, délivrant, avec le cadencement régulier choisi, les valeurs représentatives des fonctions $\sin(\alpha_r + k\Phi)$, $\sin(\alpha_r + (k-1)\Phi)$, $\cos(\alpha_r + k\Phi)$, $\cos(\alpha_r + (k-1)\Phi)$, relatives au signal modulé constitué de:

a. un premier multiplexeur d'entrée (80) sélectionnant la valeur de $\alpha_r$ issue du dixième dispositif de calcul (52) puis les valeurs successives $\alpha_r + k\Phi$ issues d'un douzième dispositif de calcul (83);

b. un onzième dispositif de calcul (81) recevant sur sa première entrée la sortie du premier multiplexeur (80) et sur sa seconde entrée une représentation numérique du déphasage angulaire $\Phi$;

c. un sixième registre (82) destiné à répartir sur deux temps successifs dudit cadencement choisi, le fonctionnement du circuit en boucle fermée formé du premier multiplexeur (80), du onzième dispositif de calcul (81), du douzième dispositif de calcul (83) et dudit sixième registre (82);

d. un comparateur numérique (84) opérant la comparaison de la sortie du sixième registre (82) avec une représentation numérique de la constante $2\pi$;

e. un douzième dispositif de calcul (83) délivrant $\alpha_r$ modulo $2\pi$;

f. un septième registre (90) destiné à conserver à la cadence choisie, le résultat du calcul issu du douzième dispositif de calcul (83);

g. un huitième registre (91) destiné à retarder d'un cycle de ladite cadence le signal de sortie du septième registre (90);

h. un treizième (92) et quatorzième (93) dispositif de calcul donnant respectivement les valeurs des fonctions $\sin(\alpha_r + k\Phi)$ et $\cos(\alpha_r + k\Phi)$;

i. un neuvième (94) et un dixième (95) registre conservant, au rythme du cadencement, les valeurs antérieures des résultats précédents $\sin(\alpha_r + (k-1)\Phi)$ et $\cos(\alpha_r + (k-1)\Phi)$;

D. un cinquième circuit (15) constitué de:

a. un sixième circuit (16) destiné à calculer les éléments permettant eux-mêmes de calculer l'amplitude d'un des signaux modulants constitué de:

a1) un dispositif à retard (60) retardant les échantillons $m_p$ prélevés par exemple en sortie du premier registre (20), afin que les échantillons arrivant sur les deux entrées d'un quinzième dispositif de calcul (62) soient en phase;

a2) un deuxième multiplexeur (61) relié en entrée aux sorties du treizième (92) et quatorzième (93) dispositif de calcul;

a3) un quinzième dispositif de calcul (62) relié en entrée à la sortie du deuxième multiplexeur (61) et à celle du dispositif à retard (60), délivrant successivement à la cadence choisie, des échantillons représentatifs des produits $m_p.\cos(\alpha_r + k\Phi)$ et $m_p.\sin(\alpha_r + k\Phi)$;

a4) un onzième registre (63) recevant les résultats $m_p.\cos(\alpha_r + k\Phi)$ et un douzième registre (64) recevant les résultats $m_p.\sin(\alpha_r + k\Phi)$, les deux dits registres fonctionnant en alternance à une cadence deux fois moins rapide que celle des circuits précédents;

b. un septième circuit (17) de conception identique au sixième circuit (16) recevant en entrée les échantillons $m_{p+1}$ décalés d'un temps de cadencement par rapport aux échantillons $m_p$, prélevés par exemple en sortie du deuxième registre (21), ledit septième circuit (17) ayant un dix-huitième dispositif de calcul (70) délivrant en alternance sur ses sorties des échantillons représentatifs des produits $m_{p+1}.\cos(\alpha_r + (k-1)\Phi)$ et $m_{p+1}.\sin(\alpha_r + (k-1)\Phi)$;

c. un seizième dispositif de calcul (65) réuni en entrée à celles des sorties, respectivement des sixième (16) et septième (17) circuits, qui ont la même alternance de la cadence deux fois moins rapide, délivrant des échantillons représentatifs de l'opération $m_{p+1}.\cos(\alpha_r + (k-1)\Phi) - m_p.\cos(\alpha_r + k\Phi)$ représentant le signal modulant v;

d. un dix-septième dispositif de calcul (67) de conception identique au seizième dispositif de calcul (65) mais opérant sur les échantillons issus, respectivement, des sixième (16) et septième (17) circuits, avec l'autre alternance de la cadence deux fois moins rapide, délivrant des échantillons proportionnels à $m_p.\sin(\alpha_r + k\Phi) - m_{p+1}.\sin(\alpha_r + (k-1)\Phi)$ représentant le signal modulant u, le cadencement d'une part et, d'autre part, les signaux de référence et modulé pouvant être synchrones ou asynchrones, ledit cadencement pouvant s'effectuer pour une large gamme de fréquences.

3. Circuit selon la revendication 2, avec les signaux de référence et modulé constitués respectivement des signaux de salve et de chrominance d'une ligne de télévision de type PAL, caractérisé en outre en ce qu'il comprend:

a. un premier circuit de mémorisation (66) et de calcul traitant les informations de deux lignes consécutives issues dudit seizième dispositif de calcul (65), selon la procédure connue pour un signal de télévision de type PAL;

b. un second circuit de mémorisation et de calcul (68) opérant d'une manière analogue au précédent mais avec les données issues du dix-septième dispositif de calcul (67).

4. Circuit selon l'une des revendications 2 ou 3, caractérisé en ce que les quinzième (62) et/ou dix-huitième (70) dispositifs de calcul ont des entrées multiplexées, permettant d'utiliser lesdits dispositifs de calcul avant leur utilisation telle que prévue, en remplacement successivement des deuxième (23), cinquième (32) et huitième (50) dispositifs de calcul selon l'instant de traitement dans la ligne de télévision, et en ce que les septième (46), neuvième (51), treizième (92) et quatorzième (93) dispositifs de calcul sont des mémoires stockant les informations précalculées.

5. Circuit selon l'une des revendications 2 à 4, caractérisé en ce que le sixième dispositif de calcul (44) utilise des coefficients correspondant à des puissances entières binaires, les calculs à l'aide desdits coefficients s'effectuant par simple décalage des données binaires.

6. Circuit selon l'une des revendications 2 à 5, caractérisé en ce que le filtre numérique (44) est un filtre transversal impair.

7. Récepteur de télévision caractérisé en ce qu'il comprend un circuit de démodulation d'amplitude selon l'une des revendications 2 à 6.

8. Circuit selon l'une des revendications 2 à 6, caractérisé en ce que le quinzième (62) et/ou le dix-huitième (70) dispositif de calcul est(sont) multiplexé(s) pour effectuer, outre la démodulation d'amplitude selon l'invention, la démodulation d'un signal modulé en fréquence selon le procédé connu mettant en œuvre la relation

$$\cos\Phi = \frac{x_n + x_{n+2}}{2(x_{n+1})},$$

les échantillons $x_n$ et $x_{n+2}$ étant prélevés respectivement en sortie du convertisseur analogique/numérique (10) et en sortie du registre (21), l'échantillon $x_{n+1}$ étant prélevé en sortie du registre (20), la somme $(x_n + x_{n+2})$ étant faite dans un additionneur puis multipliée par $1/2.x_{n+1}$ par le quinzième (62) ou le dix-huitième (70) dispositif de calcul qui délivre des données numériques représentatives des valeurs de $\cos\Phi$ propres à une modulation ou une évolution de la fréquence Fs du signal, les valeurs de $\cos\Phi$ entrant dans un quatrième dispositif de calcul (31) dont la sortie entre dans le cinquième dispositif de calcul (32).

9. Récepteur de télévision caractérisé en ce qu'il comprend un circuit de démodulation d'amplitude PAL selon l'une des revendications 2 à 6 et un circuit de démodulation de fréquence SECAM selon la revendication 8.

**Claims**

1. A method of digitally demodulating an amplitude-modulated signal, obtained by suppressed-carrier amplitude modulation of two quadrature-phase carriers of the same frequency Fs, provided with a circuit for determining the square $a^2$ of the peak amplitude $\underline{a}$ of a sinusoidal reference signal which is in synchronism with the modulated signal, and with means for sampling at a rate defined by a frequency Fe, said modulating signal being written:

$$m_{p+1} = u.\cos(\alpha + k\Phi) + v.\sin(\alpha + k\Phi)$$

wherein $\Phi = \dfrac{\omega}{Fe} = 2\pi\dfrac{Fs}{Fe}$, $\alpha$ is an initial angular phase shift and $\underline{k}$ the number of periods T = 1/Fe, characterized in that it comprises the following steps:

– determining and thereafter storing the sign of the reference signal $x_{n+m}$ and the sign of the derived of said reference signal at a predetermined instant $t_{n+m}$ for which $\underline{k}$ is given the value zero;
– determining at the instant $t_{n+m}$ the square of the sine of the initial angular phase shift denoted as the real angular phase shift $\alpha_r$ or the inverse of this square in accordance with the expression $1/\sin^2\alpha_r = a^2/x^2_{n+m}$;
– determining the values of $\sin\alpha_r$, thereafter a value $\alpha_T$ which corresponds to one of the values of

arc sin $\alpha_r$ chosen in one of the four quadrants of a customary trigonometrical presentation;
– determining the value of the real angular phase shift $\alpha_r$ from the value of $\alpha_T$, from knowledge of the selected quadrant, and from the signs of the reference signal and of the derived of said reference signal for the same instant $t_{n+m}$;
– determining and thereafter storing sequentially at each instant of the sampling rate the values $\alpha_r + k\Phi$ modulo $2\pi$;
– determining and storing sequentially pairs of values of $\sin(\alpha_r + k\Phi)$ and $\cos(\alpha_r + k\Phi)$, $\sin(\alpha_r + (k-1)\Phi)$ and $\cos(\alpha_r + (k-1)\Phi)$ for two consecutive instants of the sampling rate;
– determining values which are proportional to the modulating signals $\underline{u}$ and $\underline{v}$, from the two samples $m_p$ and $m_{p+1}$ of the modulated signal, by:
$m_p.\sin(\alpha_r + k\Phi) - m_{p+1}.\sin(\alpha_r + (k-1)\Phi)$ proportional to u
and
$m_{p+1}.\cos(\alpha_r + (k-1)\Phi) - m_p.\cos(\alpha_r + k\Phi)$ proportional to v.

2. A digital circuit for putting into effect a method of digitally demodulating an amplitude-modulated signal, obtained by suppressed-carrier amplitude modulation of two quadrature-phase carriers of the same frequency Fs, provided with a determination of the square $a^2$ of the peak amplitude $\underline{a}$ of a sinusoidal reference signal which is in synchronism with the modulated signal, and with means for sampling at a rate defined by a frequency Fe, said modulating signal being written:

$$m_{p+1} = u.\cos(\alpha + k\Phi) + v.\sin(\alpha + k\Phi)$$

wherein $\Phi = \dfrac{\omega}{Fe} = 2\pi\dfrac{Fs}{Fe}$, $\alpha$ is an initial angular phase shift and $\underline{k}$ the number of periods T = 1/Fe, the digital circuit including a first circuit (11) allowing to determine the square $a^2$ of the peak amplitude $\underline{a}$ of a reference signal which is in synchronism with said modulated signal, said first circuit (11) comprising an analog-to-digital converter (10), first and second registers (20) and (21), first (22), second (23), third (24), fourth (31) and fifth (32) calculating arrangements, the latter supplying from its output samples which are representative of the square $a^2$ of the peak amplitude of said reference signal, characterized in that it comprises:

A. a second circuit (12) by means of which at a chosen instant $t_{n+m}$ at which a sample $x_{n+m}$ appears, the sign of the reference signal and the sign of the derived of said reference signal for this same instant are determined, formed by:
a. a sub-circuit (49) for determining the derived of a signal, for example of the digital filter type, which itself is formed by:
a1) a series arrangement of a certain number of registers, for example third (41), fourth (42) and fifth (43) registers, intended to store consecutive samples

$x_{n+m+i}$ to $x_{n+m-j}$ originating, for example, from the second register (21);

  a2) a sixth calculating arrangement (44) to which the samples $x_{n+m+i}$ to $x_{n+m-j}$ are applied, which calculates by means of the known digital filtering method, and at the instant $t_{n+m}$, the derived of the signal represented by said samples;

b. a storage device (45) intended to preserve said information components about the sign of the reference signal and the sign of the derived of this same reference signal;

c. a seventh calculating arrangement (46) connected by means of its input to the output of the fourth register (42) storing $x_{n+m}$, and supplying the samples which are representative of the function $1/x^2_{n+m}$;

B. a third circuit (43), by means of which the angular phase shift $\alpha_r$ modulo $2\pi$ can be calculated for said sample $x_{n+m}$, formed by:

  a. an eighth calculating arrangement (50) to which the information components coming from the fifth (32) and seventh (46) calculating arrangements are applied and which supplies from its output samples which are representative of the function $1/\sin^2\alpha = a^2/x^2_{n+m}$;

  b. a ninth calculating arrangement (51) which has its input connected to the output of the eighth calculating arrangement (50), and supplying from its output samples, denoted $\alpha_T$ hereinafter, representing the function arc $\sin \alpha_r$, determined for one of the four quadrants chosen at the start, of a customary trigonometric presentation;

  c. a tenth calculating arrangement (52) which has its input connected to the output of the ninth calculating arrangement (51) and to two outputs of the storage device (45), effecting from the value of $\alpha_T$, the calculation of the real angular phase shift $\alpha_r$ in the interval 0 to $2\pi$;

C. a fourth circuit (14), which processes the modulated signal at the end of the calculation of $\alpha_r$, supplying, at the chosen regular rate, the values representative of the functions $\sin(\alpha_r+k\Phi)$, $\sin(\alpha_r+(k-1)\Phi)$ $\cos(\alpha_r+k\Phi)$, $\cos(\alpha_r+(k-1)\Phi)$, relative to the modulated signal formed by:

  a. a first input multiplexer (80) which selects the value of $\alpha_r$ supplied by the tenth calculating arrangement (52) and thereafter the consecutive values $\alpha_r+k\Phi$ supplied by the twelfth calculating arrangement (83);

  b. an eleventh calculating arrangement (81) receiving at its first input the output of the first multiplexer (80) and at its second input a digital representation of the angular phase shift $\Phi$;

  c. a sixth register (82) intended to divide over two consecutive time periods of said chosen rate, the operation of the closed-loop circuit formed by the first multiplexer (80), the eleventh calculating arrangement (81), the twelfth calculating arrangement (83) and said sixth register (82);

  d. a digital comparator (84) effecting the comparison between the output of the sixth register (82) and a digital representation of the constant $(2)\pi$;

  e. a twelfth calculating arrangement (83) supplying $\alpha_r$ modulo $2\pi$;

  f. a seventh register (90) intended to preserve at the chosen rate the result of the calculation effected by the twelfth calculating arrangement (83);

  g. an eighth register (91) intended to delay said output signal rate of the seventh register (90) by one cycle;

  h. thirteenth (92) and fourteenth (93) calculating arrangements which produce the respective values of the functions $\sin(\alpha_r+k\Phi)$ and $\cos(\alpha_r+k\Phi)$;

  i. ninth (94) and tenth (95) registers preserving, at the chosen rates, the previous values of the preceding results $\sin(\alpha_r+(k-1)\Phi)$ and $\cos(\alpha_r+(k-1)\Phi)$

D. a fifth circuit (15) formed by:

  a. a sixth circuit (16) intended to calculate the elements by means of which it is possible to calculate the amplitude of one of the modulating signals constituted by:

    a1) a delay device (60) which delays the samples $m_p$ taken, for example, from the output of the first register, so as to ensure that the samples which arrive at the two inputs of a fifteenth calculating arrangement (62) are in phase;

    a2) a second multiplexer (61) connected by means of its input to the outputs of the thirteenth (92) and fourteenth (93) calculating arrangements.

    a3) a fifteenth calculating arrangement (62) connected by means of its input to the output of the second multiplexer (61) and to the output of the delay device (60), which produces sequentially at the chosen rate samples which are representative of the product $m_p.\cos(\alpha_r+k\Phi)$ and $m_p.\sin(\alpha_r+k\Phi)$;

    a4) an eleventh register (63) to which the results $m_p.\cos(\alpha_r+k\Phi)$ are applied and a twelfth register (64) to which the results $m_p.\sin(\alpha_r+k\Phi)$ are applied, said two registers alternately operating at a rate which is twice as low as that of the preceding circuits;

  b. a seventh circuit (17) of a design which is identical to the sixth circuit (16), which receives at its input the samples $m_{p+1}$ shifted through one period of the rate relative to the samples $m_p$, which are, for example, taken from the output of the second register (21), said seventh circuit (17) having an eighteenth calculating arrangement (70) which supplies alternately from its outputs samples which are representative of the

products $m_{p+1}.\cos(\alpha_r + (k-1)\Phi)$ and $m_{p+1}.\sin(\alpha_r(k-1)\Phi)$;

   c. a sixteenth calculating arrangement (65) connected by means of its input to outputs of respectively the sixth (16) and seventh (17) circuits, which have the same alternation of the twice lower rate, supplying samples which are representative of the operation $m_{p+1}.\cos(\alpha_r + (k-1)\Phi)$ — $m_p.\cos(\alpha_r + k\Phi)$ representing the modulating signal v;

   d. a seventeenth calculating arrangement (67) of a design which is identical to the sixteenth calculation arrangement (65) but acts on the samples supplied by the sixth (16) and. seventh (17) circuits, respectively, at the other alternation of the twice lower rate and supplying samples which are proportional to $m_p.\sin(\alpha_r + k\Phi) - m_{p+1}.\sin(\alpha_r + k-1)\Phi)$ representing the modulating signal u, it being possible for the rates of the reference signal on the one hand and of the modulated signal on the other hand to be synchronous or asynchronous, it being possible for this rate to occur over a wide frequency range.

3. A circuit as claimed in Claim 2, having reference signals and modulated signals which are constituted by burst signals and chrominance signals of a television line of the PAL type, respectively, characterized inter alia in that it comprises:

   a. a first storage and calculating circuit (66) processing the information components of two consecutive lines supplied by said sixteenth calculating arrangement (65) in accordance with the known method for a television signal of the PAL type;

   b. a second storage and calculating circuit (68) whose mode of operation is similar to the preceding storage and calculating arrangement but which processes the data supplied by the seventeenth calculating arrangement (67).

4. A circuit as claimed in any of the Claims 2 or 3, characterized in that the fifteenth (62) and/or seventeenth (70) calculating arrangements have multiplexed inputs which allow the use of said calculating arrangements before their intended use, by replacing successively the second (23), fifth (32) and eighth (50) calculating arrangements depending on the instant at which the television line is processed, and in that the seventh (46), ninth (50), thirteenth (92) and fourteenth (93) calculating arrangements are memories in which the pre-calculated information components are stored.

5. A circuit as claimed in any of the Claims 2 to 4, characterized in that the sixth calculating arrangement (44) uses coefficients which correspond to binary integral powers, the calculations with the aid of said coefficients being effected by simply shifting the binary data.

6. A circuit as claimed in any of the Claims 2 to 5, characterized in that the digital filter (44) is an odd transversal filter.

7. A television receiver characterized in that it comprises an amplitude demodulation circuit as claimed in any of the Claims 2 to 6.

8. A circuit as claimed in any of the Claims 2 to 6, characterized in that the fifteenth (62) and/or the eighteenth (70) calculating arrangement is (are) multiplexed to effect, in addition to the amplitude demodulation according to the invention, the demodulation of a frequency-modulated signal in accordance with the known method using the relation

$$\cos\Phi = \frac{x_n + x_{n+2}}{2(x_{n+1})},$$

the samples $x_n$ and $x_{n+2}$ being taken from the output of the analog-to-digital converter (10) and the output of the register (21), the sample $x_{n+1}$ being taken from the output of the register (20), the sum $(x_n + x_{n+2})$ being taken in an adder and thereafter being multiplied by $1/(2x_{n+1})$ by the fifteenth (62) or eighteenth (70) calculating arrangements which supply the digital data which are representative of the values of cos $\Phi$ suitable for a modulation of a development of the frequency Fs of the signal, the values of cos $\Phi$ being applied to a fourth calculating arrangement (31) whose output is applied to the fifth calculating arrangement (32).

9. A television receiver, characterized in that it comprises a PAL amplitude demodulation circuit as claimed in any of the Claims 2 to 6 and a SECAM frequency demodulation circuit as claimed in Claim 8.

**Patentansprüche**

1. Verfahren zur digitalen Demodulation eines amplitudenmodulierten Signals, das durch trägerausgetastete Amplitudenmodulation zweier Quadraturphasenträger mit derselben Frequenz Fs erhalten worden ist, mit einer Bestimmung des Quadrats $a^2$ der Spitzenamplitude a eines sinusförmigen zu dem modulierten Signal synchronen Bezugssignals und mit Möglichkeiten zum mit einer durch die Frequenz Fe bestimmten Abtastung Abtasten, wobei sich das modulierte Signal wie folgt schreiben lässt:

$$m_{p+1} = u.\cos(\alpha + k\Phi) + v.\sin(\alpha + k\Phi)$$

wobei $\Phi = \omega/Fe = 2\pi Fs/Fe$ ist,
α eine Anfangswinkelphasenverschiebung ist und
k die Anzahl Perioden T = 1/Fe ist,
dadurch gekennzeichnet, dass das Verfahren die folgenden Verfahrensschritte aufweist:
— Bestimmen und nachfolgendes Speichern des Vorzeichens des Bezugssignals $x_{n+m}$ und des Vorzeichens des abgeleiteten Wertes des genannten Bezugssignals zu einem vorbestimmten Zeitpunkt $t_{n+m}$, wobei für k der Wert Null gewählt worden ist;
— zu dem Zeitpunkt $t_{n+m}$ Bestimmen des Quadrats des Sinus der Anfangswinkelphasenverschiebung, die als Ist-Winkelphasenverschiebung $\alpha_r$ benannt ist, oder des invertierten Wertes dieses Quadrates entsprechend dem Ausdruck $1/\sin^2\alpha_r$ $= a^2/x^2_{n+m}$;

– Bestimmen der Werte des $\sin\alpha_r$, und danach eines Wertes $\alpha_T$ entsprechend einem der Werte des arc $\sin\alpha_r$ gewählt in einem der vier Quadranten einer normalen trigonometrischen Darstellung;

– Bestimmen des Wertes der Ist-Winkelphasenverschiebung $\alpha_r$, ausgehend von einem Wert von $\alpha_T$, vom Bekanntsein des gewählten Quadranten und von den Vorzeichen des Bezugssignals und des abgeleiteten Wertes des genannten Bezugssignals zu demselben Zeitpunkt $t_{n+m}$;

– Bestimmen und nachfolgendes Speichern jeweils zu jedem Zeitpunkt der Abtastung der Werte $\alpha_r + k\Phi$ modulo $2\pi$;

– Bestimmen und nachfolgendes Speichern von Paaren von Werten von $\sin(\alpha_r + k\Phi)$ und $\cos(\alpha_r + k\Phi)$, $\sin(\alpha_r + (k-1)\Phi)$ und $\cos(\alpha_r + (k-1)\Phi)$ zu zwei aufeinanderfolgenden Zeitpunkten der Abtastung;

– Bestimmen von Werten, die den Modulationssignalen u und v proportional sind, aus den zwei Abtastwerten $m_p$ und $m_{p+1}$ des modulierten Signals durch:

$m_p.\sin(\alpha_r + k\Phi) - m_{p+1}.\sin(\alpha_r + (k-1)\Phi)$ proportional zu u und

$m_{p+1}.\cos(\alpha_r + (k-1)\Phi) - m_p.\cos(\alpha_r + k\Phi)$ proportional zu v.

2. Digitale Schaltungsanordnung zum Durchführen eines Verfahrens zum digitalen Demodulieren eines amplitudenmodulierten Signals, das durch trägerausgetastete Amplitudenmodulation zweier Quadraturphasenträger mit derselben Frequenz Fs erhalten worden ist, mit einer Bestimmung des Quadrats $a^2$ der Spitzenamplitude a eines sinusförmigen zu dem modulierten Signal synchronen Bezugssignals und mit Möglichkeiten zum mit einer durch die Frequenz Fe bestimmten Abtastung Abtasten, wobei sich das modulierte Signal wie folgt schreiben lässt:

$$m_{p+1} = u.\cos(\alpha + k\Phi) + v.\sin(\alpha + k\Phi)$$

wobei $\Phi = \omega/Fe = 2\pi Fs/Fe$ ist, $\alpha$ eine Anfangswinkelphasenverschiebung ist und k die Anzahl Perioden $T = 1/Fe$ ist, wobei die digitale Schaltungsanordnung eine erste Schaltungsanordnung (11) zum Ermöglichen der Bestimmung des Quadrats $a^2$ der Spitzenamplitude a eines sinusförmigen zu dem modulierten Signal synchronen Bezugssignal enthält, wobei die genannte erste Schaltungsanordnung (11) einen Analog-Digital-Wandler (10), erste (20) und zweite (21) Register sowie eine erste (22), eine zweite (23), eine dritte (24), eine vierte (31) und eine fünfte (32) Rechenanordnung aufweist, wobei diese letztere an ihrem Ausgang Abtastwerte liefert, die für das Quadrat $a^2$ der Spitzenamplitude des genannten Bezugssignals repräsentativ sind, dadurch gekennzeichnet, dass die Schaltungsanordnung die folgenden Elemente aufweist:

A. eine zweite Schaltungsanordnung (12) durch die zu einem bestimmten Zeitpunkt $t_{n+m}$, an dem ein Abtastwert $x_{n+m}$ auftritt, das Vorzeichen des Bezugssignals und das Vorzeichen des abgeleiteten Wertes des genannten Bezugssignals an diesem selben genannten Zeitpunkt bestimmt werden, wobei diese zweite Schaltungsanordnung die folgenden Elemente enthält:

a. eine Teilschaltungsanordnung (49) zum Bestimmen des abgeleiteten Wertes eines Signals, beispielsweise vom digitalen Filtertyp, die ihrerseits mit den folgenden Elementen gebildet ist:

a1) einer Reihenschaltung aus einer bestimmten Anzahl Registern, beispielsweise einem dritten (41), einem vierten (42) und einem fünften (43) Register, die dazu bestimmt sind, aufeinanderfolgende Abtastwerte $x_{n+m+i}$ bis $x_{n+m-j}$, die beispielsweise von dem zweiten Register (21) herrühren, zu speichern,

a2) einer sechsten Rechenanordnung (44), der die Abtastwerte $x_{n+m+i}$ bis $x_{n+m-j}$ zugeführt werden, wobei diese Rechenanordnung mittels des bekannten digitalen Filterverfahrens und zu dem Zeitpunkt $t_{n+m}$ den abgeleiteten Wert des durch die genannten Abtastwerte dargestellten Signals berechnet;

b. eine Speicheranordnung (45) zum Aufbewahren der genannten Informationanteile betreffs des Vorzeichens des Bezugssignals und des Vorzeichens des abgeleiteten Wertes desselben Bezugssignals;

c. eine siebente Rechenanordnung (46), die mittels des Eingangs mit dem Ausgang des vierten den Abtastwert $x_{n+m}$ speichernden Registers (42) gekoppelt ist und die Abtastwerte liefert, die für die Funktion $1/x^2_{n+m}$ repräsentativ sind;

B. eine dritte Schaltungsanordnung (13), durch welche die Winkelphasenverschiebung $\alpha_r$ modulo $2\pi$ für den Abtastwert $x_{n+m}$ berechnet werden kann, wobei diese dritte Schaltungsanordnung die folgenden Teile enthält:

a. eine achte Rechenanordnung (50), der die von der fünften (32) und siebenten (46) Rechenanordnung herrührenden Informationsanteile zugeführt werden und die an ihrem Ausgang Abtastwerte liefert, die für die Funktion $1/\sin^2\alpha_r = a^2/x^2_{n+m}$ repräsentativ sind;

b. eine neunte Rechenanordnung (51), deren Eingang mit dem Ausgang der achten Rechenanordnung (50) gekoppelt ist und die an ihrem Ausgang Abtastwerte liefert, die untenstehend als $\alpha_T$ bezeichnet werden und die Funktion arc $\sin\alpha_r$ darstellen, und die bestimmt sind für einen der am Anfang gewählten Quadranten einer gebräuchlichen trigonometrischen Repräsentation;

c. eine zehnte Rechenanordnung (52), deren Eingang mit dem Ausgang der neunten Rechenanordnung (51) sowie mit zwei Ausgängen der Speicheranordnung (45) gekoppelt ist, wodurch ausgehend von dem Wert $\alpha_T$ die Berechnung der Ist-Winkelphasenverschiebung $\alpha_r$ in dem Intervall 0 bis $2\pi$ erhalten wird;

C. eine vierte Schaltungsanordnung (14), die das modulierte Signal am Ende der Berechnung von $\alpha_r$ behandelt, wodurch mit der gewählten regulären Abtastung die Werte erhalten werden, welche die Funktionen $\sin(\alpha_r+k\Phi)$ und $\cos(\alpha_r+k\Phi)$, $\sin(\alpha_r+(k-1)\Phi)$ und $\cos(\alpha_r+(k-1)\Phi)$ in bezug auf das modulierte Signal darstellen, wobei diese Schaltungsanordnung die folgenden Elemente enthält;

a. einen ersten Eingangsmultiplexer (80), der den Wert von $\alpha_r$ wählt, der von der zehnten Rechenanordnung (51) geliefert wird und danach die aufeinanderfolgenden Werte $\alpha_r+k\Phi$ wählt, die von der zwölften Rechenanordnung (83) geliefert werden;

b. eine elfte Rechenanordnung (81), die an ihrem ersten Eingang das Ausgangssignal des ersten Multiplexers (80) erhält und an ihrem zweiten Eingang eine digitale Darstellung der Winkelphasenverschiebung $\Phi$;

c. einen sechsten Register (82) zum über zwei aufeinanderfolgende Zeitperioden der genannten gewählten Abtastung Verteilen der Wirkung der mit dem ersten Multiplexer (80), der elften Rechenanordnung (81), der zwölften Rechenanordnung (83) und dem genannten sechsten Register (82) gebildeten geschlossenen Schleifenschaltung;

d. eine digitale Vergleichsanordnung (84) zum Vergleichen des Ausgangssignals des sechsten Registers (82) mit einer digitalen Darstellung der Konstanten $2\pi$;

e. eine zwölfte Rechenanordnung (83), die den Wert $\alpha_r$ modulo $2\pi$ liefert;

f. einen siebenten Register (90) zum mit der gewählten Abtastung Aufbewahren des Rechenergebnisses der zwölften Rechenanordnung (83);

g. einen achten Register (91) zum Verzögern des genannten Ausgangssignals des siebenten Registers (90) um einen Zyklus der genannten Abtastung;

h. eine dreizehnte (92) und vierzehnte (93) Rechenanordnung, welche die betreffenden Werte der Funktionen $\sin(\alpha_r+k\Phi)$ und $\cos(\alpha_r+k\Phi)$ erzeugen;

i. einen neunten (94) und zehnten (95) Register zum mit der Geschwindigkeit der Abtastung Aufbewahren der vorhergehenden Werte der vorstehenden Ergebnisse $\sin(\alpha_r+(k-1)\Phi)$ und $\cos(\alpha_r+(k-1)\Phi)$;

D. eine fünfte Schaltungsanordnung (15), die mit den folgenden Teilen gebildet ist:

a. einer sechsten Schaltungsanordnung (16) zum Berechnen der Elemente, durch die es möglich ist, die Amplitude eines der modulierenden Signale zu berechnen, wobei diese sechste Schaltungsanordnung die folgenden Elemente enthält:

a1) eine Verzögerungsschaltung (60), welche die Abtastwerte $m_p$ von beispielsweise dem Ausgang des ersten Registers (20) verzögert um zu gewährleisten, dass die an den zwei Eingängen der fünfzehnten Rechenanordnung (62) eintreffenden Abtastwerte phasengleich sind;

a2) einen zweiten Multiplexer (61), der mittels seines Eingangs mit den Ausgängen der dreizehnten (92) und vierzehnten (93) Rechenanordnung gekoppelt ist;

a3) eine fünfzehnte Rechenanordnung (62), die mittels ihres Eingangs mit dem Ausgang des zweiten Multiplexers (61) und mit dem Ausgang der Verzögerungsschaltung (60) gekoppelt ist, wobei diese fünfzehnte Rechenanordnung sequentiell mit der gewählten Abtastung Abtastwerte erzeugt, die für die Produkte $m_p \cdot \cos(\alpha_r+k\Phi)$ und $m_p \cdot \sin(\alpha_r+k\Phi)$ repräsentativ sind;

a4) einen elften Register (63), dem die Ergebnisse $m_p \cdot \cos(\alpha_r+k\Phi)$ zugeführt werden sowie einen zwölften Register (64), dem die Ergebnisse $m_p \cdot \sin(\alpha_r+k\Phi)$ zugeführt werden, wobei die zwei genannten Register mit einer Abwechslung auf einer Abtastungsfrequenz arbeiten, die zweimal niedriger ist als die der vorstehenden Schaltungsanordnungen;

b. einer siebenten Schaltungsanordnung (17) don demjenigen Typ, der der sechzehnten Schaltungsanordnung (16) entspricht, die an ihrem Eingang die um eine Abtastungsperiode gegenüber den Abtastwerden $m_p$ verschobenen Abtastwerte $m_{p+1}$ erhält, die beispielsweise dem Ausgang des zweiten Registers (21) entnommen worden sind, wobei die genannte siebente Schaltungsanordnung (17) eine achtzehnte Rechenanordnung (70) aufweist, die wechselweise an ihren Ausgängen Abtastwerte liefert, die für die Produkte $m_{p+1} \cdot \cos(\alpha_r+(k-1)\Phi)$ und $m_{p+1} \cdot \sin(\alpha_r+(k-1)\Phi)$ repräsentativ sind;

c. einer sechzehnten Rechenanordnung (65) die mittels ihrer Eingänge mit dem Ausgang der sechsten (16) bzw. siebten (17) Schaltungsanordnung die mit derselben Abwechslung auf der zweimal niedrigeren Abtastungsfrequenz arbeiten, gekoppelt ist, wobei diese Rechenanordnung Abtastungswerte liefert, die für die Bearbeitung $m_{p+1} \cdot \cos(\alpha_r+(k-1)\Phi) - m_p \cdot \cos(\alpha_r+k\Phi)$, die das modulierende Signal $v$ darstellt, repräsentativ sind;

d. einer siebzehnten Rechenanordnung (67) von dem Typ, der der sechzehnten Rechenanordnung (65) entspricht, die aber die Abtastwerte bearbeitet, die von der sechsten (16) bzw. siebten (17) Schaltungsanordnung die mit einer anderen Abwechslung auf der zweimal niedrigeren Abtastungsfrequenz arbeiten, geliefert werden, wobei diese siebzehnte Rechenanordnung Abtastwerte liefert, die zu dem das modulierende Signal u darstellenden Wert $m_p.\sin(\alpha_r + k\Phi) - m_{p+1}.\sin(\alpha_r + (k-1)\Phi)$ proportional sind, wobei die Abtastung des Bezugssignals und die des modulierten Signals synchron oder asynchron können sein, wobei die genannte Abtastungsfrequenz über einen grossen Frequenzbereich auftreten kann.

3. Schaltungsanordnung nach Anspruch 1 mit Bezugssignalen und modulierten Signalen, die durch Farbsynchronsignale bzw. Farbartsignale einer Fernsehzeile vom PAL-Typ gebildet werden, ausserdem dadurch gekennzeichnet, dass sie die folgenden Elemente aufweist:

    a. eine erste Speicher- und Rechenschaltung (66), welche die Informationanteile zweier aufeinanderfolgender Zeilen behandelt, die von der genannten sechzehnten Rechenanordnung (65) entsprechend dem bekannten Verfahren für ein PAL-Fernsehsignal geliefert werden;

    b. eine zweite Speicher- und Rechenanordnung (68), deren Betriebsart der der vorhergehenden Speicher- und Rechenanordnung entspricht, die aber die von der siebzehnten Rechenanordnung (67) gelieferten Daten behandelt.

4. Schaltungsanordnung nach einem der Ansprüche 2 oder 3, dadurch gekennzeichnet, dass die fünfzehnte (62) und/oder achtzehnte (70) Rechenanordnung multiplexte Eingänge haben, wodurch diese Rechenanordnungen vor ihrem eigentlichen Gebrauch benutzt werden können, indem sie nacheinander die zweite (23), fünfte (32) und achte (50) Rechenanordnung ersetzen und zwar abhängig von dem Behandlungszeitpunkt in der Fernsehzeile, und dass die siebte (46), neunte (51), dreizehnte (92) und vierzehnte (93) Rechenanordnungen Speicheranordnungen sind, in denen die vorberechneten Informationen gespeichert werden.

5. Schaltungsanordnung nach einem der Ansprüche 2 bis 4, dadurch gekennzeichnet, dass die sechste Rechenanordnung (44) Koeffizienten benutzt, die ganzen binären Potenzen entsprechen, wobei die Berechnungen mit Hilfe der genannten Koeffizienten durch einfache Verschiebung der binären Daten durchgeführt werden.

6. Schaltungsanordnung nach einem der Ansprüche 2 bis 5, dadurch gekennzeichnet, dass das Digitalfilter (44) ein ungerades Transversalfilter ist.

7. Fernsehempfänger, dadurch gekennzeichnet, dass dieser eine Amplitudendemodulationsschaltung nach einem der Ansprüche 2 bis 6 aufweist.

8. Schaltungsanordnung nach einem der Ansprüche 2 bis 6, dadurch gekennzeichnet, dass die fünfzehnte (62) und/oder achtzehnte (70) Rechenanordnung multiplext ist (sind), um ausser der erfindungsgemässen Amplitudendemodulation die Demodulation eines frequenzmodulierten Signals durchzuführen und zwar entsprechend dem bekannten Verfahren für die Beziehung

$$\cos\Phi = \frac{x_n + x_{n+2}}{2(x_{n+1})}$$

wobei die Abtastwerte $x_n$ und $x_{n+2}$ dem Ausgang des Analog-Digital-Wandlers (10) bzw. dem Ausgang des Registers (21) entnommen werden, wobei der Abtastwert $x_{n+1}$ dem Ausgang des Registers (20) entnommen wird, während die Summe $(x_n + x_{n+2})$ in einem Addierer gemacht wird, und zwar nach einer Multiplikation mit $1/(2.x_{n+1})$ mittels der fünfzehnten (62) oder der achtzehnten (70) Rechenanordnung, welche die digitalen Daten liefert, die repräsentativ sind für die Werte von $\cos\Phi$, die spezifisch sind für eine Modulation oder eine Weiterentwicklung der Frequenz Fs des Signals, wobei die Werte von $\cos\Phi$ einer vierten Rechenanordnung (31) zugeführt werden, deren Ausgangssignal der fünften Rechenanordnung (32) zugeführt wird.

9. Fernsehempfänger, dadurch gekennzeichnet, dass dieser eine PAL-Amplitudendemodulationsschaltung nach einem der Ansprüche 2 bis 6 sowie eine SECAM-Frequenzdemodulationsschaltung nach Anspruch 8 aufweist.

EP 0 137 553 B1

FIG.1a

17

FIG.1b

FIG.1c

FIG.1d

FIG.2